# FASCICULE DE BREVET EUROPEEN

(11) **EP 1 217 404 B1**
(45) Date de publication et mention de la délivrance du brevet: **23.07.2003**
(21) Numéro de dépôt: 01000562.7
(22) Date de dépôt: 22.10.2001
(51) Int. Cl.: G02B 6/42

(54) **Dispositif opto-électronique, comportant un émetteur et/ou récepteur monté sur un circuit imprimé appliqué contre un radiateur de refroidissement**
Optoelektronisches Modul mit einem Sender/Empfänger, montiert auf eine Platine, aufgebracht auf einem Kühler
Opto-electronic module with a transmitter/receiver mounted onto a printed circuit board in contact with a cooling radiator

(30) Priorité: 26.10.2000 FR 0013767
(43) Date de publication de la demande: 26.06.2002
(73) Titulaire: FCI, 92400 Courbevoie (FR)
(72) Inventeur: BELHORA, Abdelkrim, 91560, CROSNE (FR); STRICOT, Yves, 78 450, VERSAILLES (FR)
(74) Mandataire: Schmit, Christian Norbert Marie

(56) Documents cités:
- EP-A- 0 314 651
- US-A- 3 766 439
- US-A- 4 763 225
- US-A- 5 011 256
- US-A- 5 168 537
- US-A- 5 241 614
- US-A- 5 396 573

## Description

La présente invention a pour objet un dispositif optoélectronique émetteur et/ou récepteur. Elle trouve plus particulièrement son utilisation dans le domaine des connexions optiques à haut débit, notamment celles respectant des normes d'usage dans les télécommunications. Dans l'état de la technique, on connaît un dispositif de ce type comportant un circuit imprimé sur lequel est disposé un émetteur/récepteur optique, pour émettre ou recevoir ces signaux optiques échangés avec un connecteur optique disposé en vis-à-vis de cet émetteur récepteur optique. De tels dispositifs dissipent beaucoup d'énergie, et sont généralement munis d'un radiateur pour assurer leur refroidissement. L'intérêt de l'invention est qu'elle présente un dispositif optoélectronique muni d'un radiateur, de telle sorte que le radiateur sert également de support mécanique au dispositif.

Dans l'état de la technique, on connaît une liaison optique parallèle, de l'enseignement du document IEEE 078035234 3/99 Electronic Competence and Technologic Conference. Cette liaison optique parallèle met en oeuvre un émetteur/récepteur et un connecteur complémentaire relié à une fibre optique. A cet effet, elle comporte un circuit imprimé sur lequel est présenté un émetteur/récepteur présentant des photodiodes alignées, le circuit imprimé étant conçu de manière à ce que le connecteur complémentaire puisse être monté à la surface de ce circuit imprimé et présenté en vis-à-vis de l'émetteur/récepteur optique. Par exemple, le connecteur complémentaire présente des extrémités de fibres optiques reliées à ce connecteur avec un écartement de ses extrémités égal à l'écartement entre les photodiodes de l'émetteur récepteur.

De plus, pour assurer le montage correct du connecteur complémentaire sur le circuit imprimé, le circuit imprimé comporte deux orifices et le connecteur comporte en correspondance deux pions de guidage. La position des extrémités des fibres optiques est précisément définie par rapport aux pions de guidage, de même la position des photodiodes est précisément définie par rapport aux orifices du circuit imprimé. Ainsi on aboutit, lors du montage du connecteur complémentaire à la surface du circuit imprimé, à une connexion optique de précision entre les fibres optiques et l'émetteur/récepteur optique.

Cette liaison optique parallèle comporte de plus une embase métallique pour pouvoir dissiper la chaleur émise par l'ensemble des composants électroniques portés par le circuit imprimé, notamment celle émise par les photodiodes. L'embase métallique est une plaque appliquée contre une face du circuit imprimé, préférentiellement en regard de l'émetteur récepteur. Dans un exemple préféré, cette embase métallique comporte également des orifices d'alignement. Ainsi, l'embase métallique peut également recevoir les pions de centrage du connecteur complémentaire.

Dans cet exemple, le circuit imprimé est flexible, et il comporte plusieurs portions permettant une connexion avec différents dispositifs. Par exemple, une première portion est destinée à être connectée avec le connecteur complémentaire. Dans ce cas, l'embase métallique est appliquée contre cette seule première portion. D'autre part, une deuxième portion du circuit imprimé est prévue pour être reliée, par un système de billes de soudure, à un autre dispositif, telle qu'une carte mère par exemple. Généralement un tel dispositif comporte une troisième portion de circuit imprimé, laquelle troisième portion est prévue plus particulièrement pour recevoir des composants passifs.

Ce dispositif optoélectronique de l'état de la technique pose un problème. En effet, un tel dispositif optoélectronique dégage beaucoup de chaleur. Or l'embase métallique prévue pour servir de radiateur est généralement d'une taille inférieure à celle du circuit imprimé. En effet, le circuit imprimé étant flexible, et les différentes portions de ce circuit n'étant pas nécessairement alignées, l'embase métallique, qui est une plaque rigide, ne peut pas suivre les différentes portions du circuit imprimé. Donc, en général l'intérêt de cette embase métallique est limité au rôle de radiateur, dans la zone très restreinte où celui-ci est disposé.

De plus, le circuit imprimé flexible risque de subir des frottements au niveau du pourtour de l'embase métallique. En effet, cette embase métallique étant locale, elle comporte des bordures présentées de manière saillante pour le circuit imprimé flexible. Par exemple, si le circuit imprimé flexible est courbé de telle sorte qu'il se replie sur l'embase métallique, alors, les bordures saillantes risquent de le couper localement. Par ailleurs, l'embase métallique étant de très fine épaisseur, cette courbure du circuit imprimé flexible peut aboutir à la formation d'un coude très serré autour de cette embase métallique et donc risquer de détériorer des pistes conductrices prévues à cet endroit sur le circuit imprimé flexible.

La présente invention a pour objet de résoudre le problème posé par le dispositif optoélectronique de l'état de la technique. En effet, le dispositif optoélectronique émetteur et/ou récepteur de l'invention prévoit plus particulièrement un dispositif comportant un circuit imprimé tel que ce circuit imprimé est appliqué contre un radiateur, ce radiateur ayant une forme telle qu'il comporte plusieurs faces distinctes. Le circuit imprimé comporte au moins un récepteur et ou émetteur optique, et peut recevoir au moins un connecteur optique complémentaire, de telle sorte que des pions de centrage de ce connecteur peuvent être insérés dans des orifices du circuit. Dans cette position de connexion, des contacts optiques du connecteur complémentaire sont disposés en vis-à-vis des contacts optiques de l'émetteur/récepteur optique du circuit.

Le circuit imprimé de l'invention est particulier car il comporte une première portion appliquée contre une première face du radiateur, et une deuxième portion de ce même circuit imprimé appliquée contre une deuxième face de ce même radiateur. La particularité de l'invention réside dans le fait que les deux faces sur lesquelles le circuit imprimé est appliqué sont distinctes, ou par exemple contiguës. Le circuit imprimé comporte de plus une portion flexible, telle que cette portion flexible assure une liaison entre la première portion et la deuxième portion. La portion flexible permet notamment de placer la première et la deuxième portion sur des plans différents. Par conséquent, le radiateur joue un rôle de support physique pour au moins ces deux portions de circuit imprimé, et les protège des détériorations.

L'invention concerne donc un dispositif optoélectronique comportant un premier élément de circuit imprimé, sur une face principale duquel est monté un émetteur et/ou récepteur optique, ce premier élément de circuit imprimé comportant au moins deux orifices pour recevoir des pions de centrage d'un connecteur optique destiné à être monté en vis-à-vis de l'émetteur et/ou récepteur optique, ce dispositif comportant en outre un radiateur, contre une première face plane duquel le premier élément de circuit imprimé est appliqué par sa face principale opposée à celle recevant l'émetteur/récepteur et le connecteur, et un deuxième élément de circuit imprimé relié par une portion de circuit imprimé flexible au premier élément de circuit imprimé, ce deuxième élément de circuit imprimé étant appliqué contre une deuxième face plane du radiateur, distincte de la première face.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1: Une vue éclatée en perpective d'un dispositif optoélectronique selon l'invention ;
- Figure 2 : Une vue d'une face d'un élément de circuit imprimé d'un dispositif optoélectronique selon l'invention.

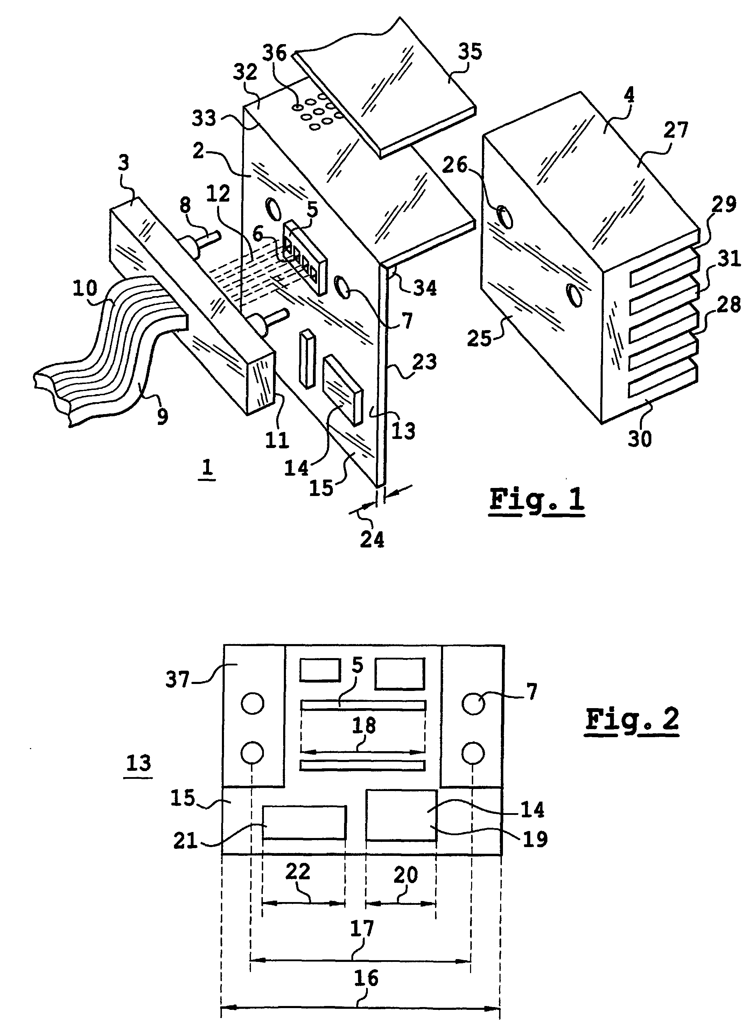

La Figure 1 présente un dispositif optoélectronique 1 selon l'invention. Le dispositif 1 comporte un circuit imprimé 2, un connecteur 3, et un radiateur 4. Le circuit imprimé 2 comporte un émetteur et/ou récepteur optique 5. L'émetteur/récepteur optique 5 comporte des contacts optiques 6 pour respectivement envoyer ou recevoir des signaux optiques. L'émetteur/récepteur 5 est un composant de conversion électro-optique Par exemple, l'émetteur/récepteur 5 est une matrice de diodes dites VCSEL (Vertical Cavity Solid Emitting Laser ; laser d'émission solide à cavité verticale), ou une matrice de photodiodes PIN. Dans une variante, les contacts optiques 6 sont des diodes, pour seulement émettre un signal. Dans cette variante, l'émetteur et/ou récepteur 5 est un simple émetteur optique.

L'émetteur/récepteur 5 peut également être une zone du circuit imprimé laissant affleurer des extrémités de fibres optiques, ces fibres optiques pouvant être par exemple incluses dans l'épaisseur du circuit imprimé. Alors les contacts optiques 6 correspondent à ces extrémités de fibres optiques.

Le circuit imprimé 2 comporte par ailleurs deux orifices 7, ces orifices 7 étant préférentiellement disposés de part et d'autre de l'émetteur/récepteur 5. Les orifices 7 forment alors une paire. Ils sont précisément positionnés vis-à-vis des contacts optiques 6. Dans une variante, on peut prévoir que le circuit imprimé 2 comporte plusieurs orifices tels que 7, et alors dans un mode de réalisation préféré de cette variante, il peut comporter plusieurs paires d'orifices 7.

Les orifices 7 sont plus particulièrement prévus pour recevoir des pions de centrage. A cet effet, des pions de centrage 8 sont présentés sur le connecteur optique 3 pour pouvoir placer ce connecteur optique 3 de manière correcte sur le circuit imprimé. De même, les pions de centrage 8 sont précisément positionnés vis-à-vis des contacts optiques (non représentés) du connecteur 3. En effet, la mise en vis-à-vis du connecteur 3 avec l'émetteur/récepteur 5 nécessite une très grande précision étant donnée la précision requise pour les liaisons optiques en général.

Le connecteur 3 est par exemple relié à un câble 9 comportant des fibres optiques 10. Les fibres optiques 10 sont par exemple agencées à l'intérieur du connecteur 3 de manière à ce que des extrémités (non représentées) de ces fibres optiques 10 soient affleurantes au niveau d'une face avant 11 du connecteur 3. Cette face avant 11 est destinée à être placée en regard de la matrice de contacts 6.

Les extrémités affleurantes des fibres optiques 10 sont alors à mettre en vis-à-vis des contacts optiques 6.

Par ailleurs, les contacts optiques 6 sont espacés de telle sorte qu'un espacement entre ces contacts optiques est de l'ordre de l'espacement de ceux présentés sur le connecteur 3. Quand le connecteur 3 est monté sur le circuit imprimé 2, les pions de centrage 8 coopèrent avec les orifices 7 à un placement correct du connecteur 3 avec le circuit imprimé 2 de manière à assurer un chemin optique correct entre ces deux éléments.

L'émetteur/récepteur 5 est plus particulièrement disposé sur un premier élément 13 de circuit imprimé 2. Ce premier élément 13 comporte par exemple d'autres dispositifs électroniques 14 montés à la surface d'une face 15 de cet élément 13. L'émetteur/récepteur 5 est également présenté sur cette face 15. Par exemple, un dispositif 14 peut être un amplificateur, ou un composant de traitement de signal. Dans ce cas, le premier élément 13 comporte des pistes (non représentées) permettant de relier l'émetteur récepteur optique 5 avec ces autres dispositifs 14. Comme présenté figure 2, ce premier élément 13 comporte, dans un exemple préféré de réalisation, deux émetteurs récepteurs tels que 5. Le circuit imprimé 2 peut ainsi recevoir un ou deux connecteurs. Dans cet exemple, le premier élément 13 comporte deux paires d'orifices 7. Les orifices d'une paire sont respectivement disposés de part et d'autre d'un émetteur récepteur 5 présenté sur cette face 15. Dans un tel cas, un connecteur complémentaire comportant deux paires de pions de centrage tels que 8 peut être monté sur ce circuit imprimé 2.

Le premier élément 13 est par exemple de taille très réduite. Par exemple une largeur 16 de cet élément 13 est de l'ordre de 10 millimètres. Dans un exemple préféré, le premier élément 13 a une forme carrée. Dans cet exemple préféré, un écart 17 entre deux orifices 7 d'une même paire est de l'ordre de 6,5 millimètres. Par conséquent, une largeur 18 d'un émetteur récepteur 5 est inférieure à l'écart 17. Par exemple cette largeur 18 est de l'ordre de 2 à 2,5 millimètres. De plus, cette face 15 présente un amplificateur 19, tel que cet amplificateur 19 a par exemple une largeur 20 de l'ordre de 1,7 millimètres. De plus, la face 15 peut comporter également un circuit de pilotage 20 d'une largeur 22 de l'ordre de 2 millimètres environ.

Le premier élément 13 de circuit imprimé 2 comporte la face 15, et également une deuxième face 23. Cette deuxième face 23 est opposée à la face 15, tout en lui étant parallèle. Le premier élément 13 est une plaque d'une épaisseur 24 faible. La face 23 est appliquée contre le radiateur 4. Dans l'exemple présenté figure 1, la face 23 est appliquée contre une première face 25 de ce radiateur 4.

Dans un mode de réalisation préféré, cette première face 25 comporte également des orifices 26, de telle sorte que, lorsque le premier élément 13 est appliqué contre la première face 25, les orifices 7 soient disposés en vis-à-vis des orifices 26. A cet effet, la première face 25 comporte au moins une paire d'orifices 26 pour être placé en vis-à-vis de la paire d'orifices tel que 7. Ainsi, lorsque le connecteur 3 est monté sur la face 15 du premier élément 13 de circuit imprimé 2, les pions de centrage 8 peuvent également être insérés dans l'orifice 26, et y être maintenus. Ainsi, les orifices 26 peuvent participer à un positionnement correct du connecteur 3 sur le circuit imprimé 2.

Le radiateur 4 est préférentiellement réalisé dans un matériau permettant de dissiper une grande quantité de chaleur. Il est caractérisé par de bonnes capacités d'échange thermique.

Le radiateur 4 permet de rigidifier la structure globale de ce dispositif 1. Par exemple, le radiateur 4 est un module de forme parallelépipédique comportant alors une deuxième face 27. Cette deuxième face 27 est distincte de la première face 25. Dans l'exemple présenté figure 1, la deuxième face 27 est sécante par rapport à la première face 25. Dans un mode de réalisation préféré, la face 25 est perpendiculaire à la deuxième face 27. Par exemple, le radiateur 4 peut comporter une face ajourée 28. Cette face ajourée 28 peut comporter une ou plusieurs cavités 29. Les cavités 29 sont creusées vers l'intérieur du parallélépipède formé par le radiateur 4. Dans l'exemple présenté figure 1, les cavités 29 ouvrent également sur au moins une autre face 30 du radiateur 4. Les cavités 29 sont séparées les unes des autres par des murs 31 d'une certaine épaisseur. Par ailleurs, la superficie totale développée par un tel radiateur 4 est nettement augmentée par le jeu de ces cavités 29 et murs 31. L'augmentation de la surface de contact entre l'environnement extérieur, par exemple l'air, et le radiateur permet une meilleure dissipation de la chaleur.

Le circuit imprimé 2 comporte également un deuxième élément 32 de circuit imprimé. Le deuxième élément 32 est relié au premier élément 13 par l'intermédiaire d'une portion de circuit imprimé fiexible 33. Dans cet exemple, le circuit imprimé 2 comporte au moins les trois portions suivantes : le premier élément 13, le deuxième élément 32 et la portion flexible 33. Par le jeu de la portion flexible 33, les éléments de circuit imprimé 13 et 32 peuvent être placés dans des plans distincts. En effet, on peut placer le circuit flexible 33 de telle sorte qu'il forme un coude 33. Dans un exemple préféré, le coude 33 forme un angle 34 de l'ordre de 90°.

Dans l'exemple présenté figure 1, le premier élément 13 et le deuxième élément 32 sont constitués de portions de circuit imprimé rigide, alors que la portion 33 est flexible. Dans une variante, on peut prévoir que les portions 13, 32 et 33 sont toutes flexibles. Dans ce cas, le circuit imprimé 2 est constitué d'un unique tenant, et les portions correspondent simplement à des orientations différentes. Les portions 13, 32 et 33 du circuit imprimé 2 sont appliquées à la périphérie du radiateur 4.

Le deuxième élément de circuit imprimé 32 présente donc une surface complémentaire du premier élément 13 pour recevoir des connecteurs, et ou des composants, et ou encore d'autres dispositifs électroniques à connecter avec le dispositif 1. Par exemple, le deuxième élément de circuit imprimé 32 peut recevoir les éléments de connexion permettant le raccordement du dispositif 1 à un dispositif complémentaire 35, par exemple sur une carte mère. Dans une mode de réalisation préféré, la connexion entre le deuxième élément 32 et le dispositif complémentaire 35 est par exemple assurée par un système de microbilles. La liaison électrique et physique réalisée par le système de microbilles est plus particulièrement décrite dans les documents US-A-6,024,584, et US-A-5,598,033. La liaison est alors assurée par des billes de soudure 36, les billes 36 étant alors disposées de manière à former un tableau respectant une certaine géométrie pour autoriser une connexion correcte unique du dispositif complémentaire 35 pouvant être connectés avec le deuxième élément 32. Les billes 36 sont micro-soudées, et sont couramment appelées "ball grid array", selon la terminologie anglo saxonne, par l'homme du métier.

Dans le mode de réalisation où le circuit imprimé est entièrement flexible et dans lequel le premier élément 13 et le deuxième élément 32 sont également flexibles, comme présenté figure 2, le dispositif 1 comporte des plaques de renfort 37. Les plaques de renfort 37 permettent de rigidifier le circuit imprimé. Ces plaques de renfort 37 sont plus particulièrement disposées au niveau des orifices 7. Par ailleurs, ces bandes de renfort 37 sont généralement disposées sur un pourtour des éléments de circuit imprimé 2 pour faciliter leur manipulation et empêcher les placements incorrects du circuit imprimé flexible 33. En effet, si le circuit imprimé est flexible, la zone où le coude doit être réalisé est incertaine mais en présence des plaques de renfort 37, ces zones de pliures sont limitées et ainsi on assure un placement correct du circuit imprimé 2 sur le radiateur 4. En effet, il existe une position préférée de la portion 13 relativement à la première face 25, et du deuxième élément 32 relativement à la deuxième face 27.

Ces plaques de renfort peuvent être d'une épaisseur calibrée de manière à contrôler l'espace entre la surface des composants optiques 6 et l'extrémité des fibres 10.

## Revendications

1. Dispositif (1) optoélectronique comportant un premier élément de circuit imprimé (13), sur une face principale (15) duquel est monté un émetteur et/ou récepteur (5) optique, ce premier élément de circuit imprimé comportant au moins deux orifices (7) pour recevoir des pions de centrage (8) d'un connecteur optique (3) destiné a être monté en vis-à-vis de l'émetteur et/ou récepteur optique, ce dispositif comportant en outre un radiateur (4), contre une première face plane (25) duquel le premier élément de circuit imprimé est appliqué par sa face principale (23) opposée à celle recevant l'émetteur/récepteur et le connecteur du radiateur, et un deuxième élément de circuit imprimé (32) relié par une portion de circuit imprimé flexible (33) au premier élément de circuit imprimé (13), ce deuxième élément de circuit imprimé (32) étant appliqué contre une deuxième face plane (27) du radiateur distincte de la première face (25).

2. Dispositif selon la revendication 1, **caractérisé en ce que** la première face plane (25) du radiateur est sécante avec la deuxième face plane (27), et **en ce que** la portion de circuit imprimé flexible (33) forme un coude.

3. Dispositif selon la revendication 2 **caractérisé en ce que** le coude forme un angle (34) d'environ 90 degrés.

4. Dispositif selon l'une des revendications 1 à 3 **caractérisé en ce qu**'au moins l'un des premier (13) et deuxième (32) éléments de circuit imprimé est rigide.

5. Dispositif selon l'une des revendications 1 à 4 **caractérisé en ce qu'**au moins l'un des premier (13) et deuxième (32) éléments de circuit imprimé est flexible et forme un circuit imprimé unique avec la portion de circuit imprimé flexible (33).

6. Dispositif selon l'une des revendications 1 à 5 **caractérisé en ce que** le radiateur (4) comporte deux réceptacles (26) sur sa premère face (25), ces réceptacles étant disposés en vis-à-vis des orifices (6) ménagés dans le premier élément de circuit imprimé (13), et permettant également la rétention des pions de centrage (8) du connecteur optique (3).

7. Dispositif selon l'une des revendications 1 à 6 **caractérisé en ce que** l'émetteur/récepteur optique (5) est disposé entre les deux orifices (7).

8. Dispositif selon l'une des revendications 1 à 7 **caractérisé en ce que** le deuxième élément de circuit imprimé (32) comporte des microbilles (36) pour pouvoir être connecté avec un autre dispositif, par exemple avec une carte mère (35).

9. Dispositif selon l'une des revendications 1 à 7 **caractérisé en ce que** le deuxième élément de circuit imprimé (32) comporte des plages de contact recevant des plots de contact d'un connecteur intermédiaire raccordant le deuxième élément de circuit imprimé à une carte électronique.

10. Dispositif selon la revendication 9 **caractérisé en ce que** le connecteur intermédiaire est constitué de deux éléments interconnectables par des terminaisons de raccordement complémentaires sur une face d'interconnexion, au moins l'élément en contact avec le deuxième élément de circuit imprimé étant muni de microbilles de soudure sur sa face de connexion avec le deuxième élément de circuit imprimé..

## Patentansprüche

1. Optoelektronische Vorrichtung (1) mit einem ersten gedruckten Schaltungselement (13), auf dessen Hauptfläche (15) ein optischer Sender und/oder Empfänger (5) angeordnet ist, wobei das erste gedruckte Schaltungselement wenigstens zwei Öffnungen (7) zur Aufnahme von Zentrierungsstiften (8) einer optischen Verbindungseinrichtung (3) zum Anordnen gegenüber dem optischen Sender und/oder Empfänger umfasst, wobei die Vorrichtung außerdem einen Radiator (4) umfasst, vor dessen erster ebenen Fläche (25) sich das erste gedruckte Schaltungselement befindet, so dass seine Hauptfläche (23) gegenüber derjenigen angeordnet ist, die den Sender/Empfänger und die Verbindungseinrichtung des Radiators aufnimmt, und ein zweites gedrucktes Schaltungselement (32) über einen flexiblen Abschnitt (33) des gedruckten Schaltkreises mit dem ersten gedruckten Schaltungselement (13) verbunden ist, wobei das zweite gedruckte Schaltungselement (32) gegenüber einer zweiten ebenen Fläche (27) des Radiators neben der ersten Fläche (25) angeordnet ist.

2. Vorrichtung nach Anspruch 1, **dadurch gekennzeichnet, dass** die erste ebene Fläche (25) des Radiators sich mit der zweiten ebenen Fläche (27) schneidet, und dass der flexible Abschnitt (33) der gedruckten Schaltung eine Biegung macht.

3. Vorrichtung nach Anspruch 2, **dadurch gekennzeichnet, dass** die Biegung einen Winkel (34) von etwa 90 Grad einschließt.

4. Vorrichtung nach einem der Ansprüche 1 bis 3, **dadurch gekennzeichnet, dass** wenigstens eines von dem ersten (13) und dem zweiten (32) gedruckten Schaltungselementen steif ist.

5. Vorrichtung nach einem der Ansprüche 1 bis 4, **dadurch gekennzeichnet, dass** wenigstens eines unter dem ersten (13) und dem zweiten (32) gedruckten Schaltungselement flexibel ist und eine einzige gedruckte Schaltung mit dem flexiblen Abschnitt (33) der gedruckten Schaltung bildet.

6. Vorrichtung nach einem der Ansprüche 1 bis 5, **dadurch gekennzeichnet, dass** der Radiator (4) zwei Aufnahmen (26) auf seiner ersten Fläche (25) aufweist, wobei diese Aufnahmen gegenüber den Öffnungen (6) in dem ersten gedruckten Schaltungselement (13) angeordnet sind und außerdem die Zentrierungsstifte (8) der optischen Verbindungseinrichtung (3) festhalten.

7. Vorrichtung nach einem der Ansprüche 1 bis 6, **dadurch gekennzeichnet, dass** der optische Sender/Empfänger (5) zwischen den beiden Öffnungen (7) angeordnet ist.

8. Vorrichtung nach einem der Ansprüche 1 bis 7, **dadurch gekennzeichnet, dass** das zweite gedruckte Schaltungselement (32) Mikrokugeln (36) für die Verbindung mit einer anderen Vorrichtung, zum Beispiel einer Basiskarte (35), aufweist.

9. Vorrichtung nach einem der Ansprüche 1 bis 7, **dadurch gekennzeichnet, dass** das zweite gedruckte Schaltungselement (32) Kontaktbereiche für die Aufnahme von Kontaktstiften einer Zwischenverbindungseinrichtung umfasst, um das zweite gedruckte Schaltungselement mit einer elektronischen Karte zu verbinden.

10. Vorrichtung nach Anspruch 9, **dadurch gekennzeichnet, dass** die Zwischenverbindungseinrichtung aus zwei Elementen aufgebaut ist, die über die Endpunkte der komplementären Verbindung auf einer Schnittfläche zusammengesetzt werden können, wobei wenigstens das Element in Kontakt mit dem zweiten gedruckten Schaltungselement ausgestattet ist mit Mikrolötkugeln auf der Verbindungsfläche mit dem zweiten gedruckten Schaltungselement.

## Claims

1. Optoelectronic device (1) comprising a first printed circuit element (13), on one main face (15) of which is mounted an optical transmitter and/or receiver (5), this first printed circuit element comprising at least two orifices (7) for receiving centring pins (8) of an optical connector (3) that is designed to be mounted facing the optical emitter and/or receiver, this device further comprising a heat sink (4), against a first plane face (25) of which the first printed circuit element is applied by its main face (23) away from the face receiving the emitter/receiver and the connector of the heat sink, and a second printed circuit element (32) connected by a portion of flexible printed circuit (33) to the first printed circuit element (13), this second printed circuit element (32) being applied against a second plane face (27) of the heat sink which is different from the first face (25).

2. Device according to Claim 1, **characterised in that** the first plane face (25) of the heat sink is secant to the second plane face (27), and **in that** the portion of flexible printed circuit (33) forms a bend.

3. Device according to Claim 2, **characterised in that** the bend makes an angle (34) of about 90 degrees.

4. Device according to one of Claims 1 to 3, **characterised in that** at least one of the first (13) and second (32) printed circuit elements is rigid.

5. Device according to one of Claims 1 to 4, **characterised in that** at least one of the first (13) and second (32) printed circuit elements is flexible and forms a single printed circuit with the portion of flexible printed circuit (33).

6. Device according to one of Claims 1 to 5, **characterised in that** the heat sink (4) comprises two receptacles (26) on its first face (25), these receptacles being placed opposite orifices (6) made in the first printed circuit element (13), and also allowing centring pins (8) of the optical connector (3) to be retained.

7. Device according to one of Claims 1 to 6, **characterised in that** the optical transmitter/receiver (5) is placed between the two orifices (7).

8. Device according to one of Claims 1 to 7, **characterised in that** the second printed circuit element (32) comprises microballs (36) in order to be able to be connected with another device, for example with a motherboard (35).

9. Device according to one of Claims 1 to 7, **characterised in that** the second printed circuit element (32) comprises contact areas receiving contact pads of an intermediate connector connecting the second printed circuit element to an electronic card.

10. Device according to Claim 9, **characterised in that** the intermediate connector consists of two elements which can be interconnected by additional connection terminals on an interconnect face, at least the element in contact with the second printed circuit element being provided with solder microballs on its face for connection with the second printed circuit element.
